Europäisches Patentamt

European Patent Office

Office européen des brevets

(11) Veröffentlichungsnummer: **0 620 445 A1**

# EUROPÄISCHE PATENTANMELDUNG

(21) Anmeldenummer: **94104116.2**

(22) Anmeldetag: **16.03.94**

(51) Int. Cl.5: **G01R 31/02**, H05K 13/08

(30) Priorität: **29.03.93 DE 4310203**

(43) Veröffentlichungstag der Anmeldung:
**19.10.94 Patentblatt 94/42**

(84) Benannte Vertragsstaaten:
**AT BE CH DE DK ES FR GB GR IE IT LI NL PT SE**

(71) Anmelder: **SIEMENS AKTIENGESELLSCHAFT**
**Wittelsbacherplatz 2**
**D-80333 München (DE)**

(72) Erfinder: **Cuylen, Michael**
**Kantstrasse 69**
**D-90513 Zirndorf (DE)**
Erfinder: **Hübsch, Bernd, Dipl.-Ing. (FH)**
**Eibenstrasse 15**
**D-90513 Zirndorf (DE)**
Erfinder: **Goller, Hugo, Dipl.-Ing. (FH)**
**Clemensstrasse 128**
**D-80797 München (DE)**

(54) **Vorrichtung zur automatischen Bestimmung der Polarität von gepolten Kondensatoren insbesondere für eine Einrichtung zur selbsttätigen Bestückung von Leiterplatten.**

(57) In einem ersten Schritt wird eine Meßspannung (+Uref) für einen ersten Zeitraum (T1) an die erste Elektrode (E1) eines Prüflingkondensators (Cx) gelegt. In einem zweiten Schritt wird die andere Elektrode (E2) mit einem Strom-Spannungsumsetzer (IU) verbunden und dessen Ausgangsspannung (-Um) für einen zweiten Zeitraum (T2) von einem Integrierer (IT) erfaßt (+Uint). In einem dritten Schritt wird die Meßspannung mit umgekehrter Polarität (-Uref) für den ersten Zeitraum (T1) an die erste Elektrode (E1)gelegt. In einem vierten Schritt wird die andere Elektrode (E2) mit dem Strom-Spannungsumsetzer (UI) verbunden und die Ausgangsspannung (+Um) für den zweiten Zeitraum (T2) vom Integrierer (IT) erfaßt(-Uint). Eine Steuer- und Auswerterschaltung (SAS) bestimmt durch Vergleich der Beträge der Spannungen am Integrierer (IT) bzw. am Strom-Spannungsumsetzer (IU) die Polaritätsrichtung.

Die Erfindung betrifft eine Vorrichtung zur automatischen Bestimmung der Polarität von gepolten Kondensatoren, insbesondere von gepolten Elektrolytkondensatoren.

Bei Elektrolytkondensatoren wird das Dielektrikum durch anodische Oxidation von Metallen erzeugt, insbesondere von Aluminium oder Tantal. Seine Wirkungsweise beruht zum Teil auf elektrochemischen Vorgängen. Dabei dient eine leitende Flüssigkeit, d.h. der Elektrolyt, als die eine Elektrode. Als Gegenelektrode dient ein metallischer Körper z.B. aus Aluminium oder Tantal, auf dessen Oberfläche durch elektrolytische Vorgänge eine Oxydschicht erzeugt wird, welche das Dielektrikum bildet. Aufgrund dieser, auf elektrochemischen Vorgängen beruhenden inneren Wirkungsweise eines Elektrolyt-Kondensators gehört dieser in der Regel zur Klasse der sogenannten "gepolten" Kondensatoren. Er funktioniert nur ordnungsgemäß, wenn an dem "formierten, d.h. oberflächlich oxydierten Metallkörper der Pluspol und an der anderen Elektrode der Minuspol angeschlossen ist. Bei umgekehrter Polung der anliegenden Spannung würde ein elektrolytischer Prozess ablaufen und an der anderen Elektrode ebenfalls eine Dielektrikumschicht aufgebaut werden. Hierbei würden eine starke innere Erwärmung und Gasbildung auftreten, die unter Umständen zur Zerstörung des Kondensators führen können.

Aus den oben genannten Gründen ist ersichtlich, daß ein gepolter Kondensator entsprechend der Herstellerkennzeichnung an den Anschlußdrähten polaritätsrichtig in eine elektrische Schaltung eingesetzt werden muß. Dies stellt bei einer manuellen Bestückung von Leiterplatten in der Regel kein Problem dar, da die Richtigpolung optisch überwacht werden kann. Bei einer vollautomatischen, selbsttätigen Bestückung von Leiterplatten mit elektrischen Bauelementen dagegen, insbesondere bei Bestückungsautomaten, welche z.B. oberflächenmontierbare SMD-Bauelemente verarbeiten, müssen besondere Maßnahmen ergriffen werden, damit gepolte Kondensatoren jederzeit polaritätsrichtig eingesetzt werden.

Aus den Europäischen Patentanmeldungen EP 0 258 516 A1 und EP 0 258 517 A1 ist jeweils ein Verfahren und eine Einrichtungen zur Erkennung der Polarität gepolter Kondensatoren bekannt.

Bei der aus der EP 0 258 516 A1 bekannten Vorrichtung wird einer konstanten, sinusförmigen Wechselspannung eine positive oder eine negative Gleichspannung überlagert. Die jeweils resultierende Spannung wird der einen Elektrode eines zu prüfenden Kondensators zugeführt und der dabei von der zweiten Elektrode des Kondensators gegen Masse fließende Strom gemessen. Die Differenz der Ströme dient als ein für die Polarität des jeweiligen Kondensators repräsentatives Ausgangssignal.

Bei der aus der EP 0 258 517 A1 bekannten Vorrichtung wird ein positiver oder ein negativer Konstantstrom der einen Elektrode eines mit der anderen Elektrode mit Masse verbundenen, zu prüfenden Kondensators zugeführt. Über eine Zeitmeßvorrichtung werden diejenigen Zeiten erfaßt, die bei Zuführung eines positiven oder negativen Konstantstromes vergehen, bis die jeweils dabei auftretende Kondensatorspannung einen vorgegebenen Wert erreicht hat. Da ein Kondensator bei richtiger Polung schneller als bei falscher Polung aufgeladen wird, kann die Differenz der Zeiten als ein für die Polarität des jeweiligen Kondensators repräsentatives Ausgangssignal dienen.

Der Erfindung liegt die Aufgabe zugrunde, eine Vorrichtung der obengenannten Art zu schaffen, welche unter Aufwendung einer möglichst geringen Meßzeit das Vorliegen einer Richtig- oder Falschpolung von gepolten Kondensatoren bestimmen kann, und welche somit besonders geeignet ist zum Einsatz in schnellaufenden Vorrichtungen, insbesondere in Bestückungsautomaten zur selbsttätigen Bestückung von Leiterplatten mit elektrischen Bauelementen.

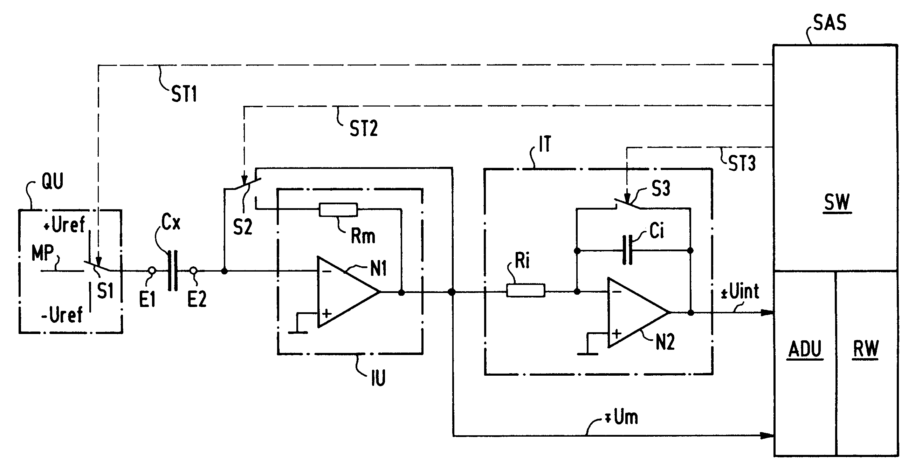

Die Aufgabe wird gelöst mit der in Anspruch 1 angegebenen Vorrichtung. Vorteilhafte Ausgestaltungen derselben sind in den Unteransprüchen enthalten. Die Erfindung wird desweiteren mit Hilfe eines in der Figur dargestellten bevorzugten Ausführungsbeispieles näher erläutert.

Gemäß den Darstellungen in der Figur soll die aktuelle Polaritätsrichtung eines Prüflingkondensators Cx vollautomatisch bestimmt werden. Hierbei handelt es sich bevorzugt um gepolte Elektrolyt-Kondensatoren, insbesondere Aluminium- bzw. Tantal-Elektrolyt-Kondensatoren. Tantal-Kondensatoren sind dabei auch in sogenannten SMD-Gehäusebauformen erhältlich, welche eine Oberflächenmontage auf der Leiterplatte ermöglichen. Insbesondere bei der Verarbeitung derartiger Kondensatorformen in schnelllaufenden SMD-Bestückungsautomaten ist es notwendig, vor der Platzierung eines jeden Kondensators dessen Richtigpolung zu überprüfen bzw. z.B. durch Drehung desselben herzustellen. Die Aufgabe besteht folglich darin, die Elektroden E1, E2 des Prüflingkondensators Cx in der Figur daraufhin zu überprüfen, welche zur Herbeiführung der Richtigpolung als Anode mit dem Pluspol und welche als Kathode mit dem Minuspol der jeweiligen Gleichspannung zu verbinden ist.

Die erfindungsgemäße Vorrichtung weist hierzu gemäß der Darstellung in der Figur eine zumindest bipolar schaltbare Gleichspannungsquelle QU auf. Diese kann an die erste Elektrode E1 des Prüflingkondensator Cx bevorzugt mit Hilfe eines ersten Umschalters S1 eine Meßspannung Uref zumindest mit positivem und mit negativem Potential +Uref, -Uref anlegen. Gemäß einer weiteren Ausführungsform der Erfindung kann die Gleichspannungsquelle QU gegebenenfalls auch das Massebezugspotential MP vorübergehend an die erste Elektrode E1 anlegen

In der Schaltung der Figur schließt sich ein zweiter Umschalter S2 an, über den die zweite Elektrode E2 des Prüflingkondensators Cx entweder mit dem Bezugspotential MP oder mit dem Eingang eines nachgeschalteten Strom-Spannungsumsetzers IU verbunden werden kann. An dessen Ausgang ist desweiteren erfindungsgemäß ein schaltbarer Integrator IT angeschlossen, der abhängig vom Potential +Uref bzw. -Uref der Gleichspannungsquelle die Ausgangspannung -Um bzw. +Um des Strom-Spannungsumsetzers IU in eine Ausgangspannung +Uint bzw. -Uint abbildet.

Die erfindungsgemäße Vorrichtung weist schließlich eine Steuer- und Auswerteschaltung SAS auf. Diese aktiviert bevorzugt mit Hilfe eines internen Steuerwerkes SW den ersten Umschalter S1 über eine Steuerleitung ST1 und den zweiten Umschalter S2 über eine Steuerleitung ST2. Eine dritte Steuerleitung ST3 dient schließlich zur Zu- bzw. Abschaltung des Integrators IT. Die Spannungen -/+ Um am Ausgang des Strom-Spannungsumsetzers IU und +/- Uint am Ausgang des Integrators IT werden im bevorzugt einem Analog-Digitalumsetzer ADU in der Steuer- und Auswerteschaltung SAS zugeführt. Bevorzugt in einem internen Rechenwerk RW wird durch Vergleich der Beträge der Spannungswerte +Uint und -Uint die Polaritätsrichtung der Elektroden E1, E2 des Prüflingskondensators Cx bestimmt.

Hierzu sind im wesentlichen vier Schritte notwendig, deren Ablauf von der Steuer- und Auswerteschaltung SAS vorgegeben wird. Im ersten Schritt wird der Prüflingkondensator auf das eine Potential der Meßspannung aufgeladen, im zweiten Schritt wird der bei unverändert anliegender Meßspannung durch den Kondensator fließende Reststrom über den Spannungs-Stromumsetzer erfaßt und in Form der Spannungen -/+ Um direkt oder unter Zuhilfenahme des Integrators IT über die Spannungen +/- Uint indirekt der Steuer- und Auswerteschaltung zugeführt. In einem dritten Schritt wird der Kondensator auf das umgekehrte Potential der Meßspannung aufgeladen, und im vierten Schritt wird wiederum der Wert des bei unverändert anliegender Meßspannung durch den Kondensator fließenden Reststromes entweder direkt in Form der Ausgangsspannungen -/+ Um des Strom- Spannungsumsetzers IU oder indirekt in Form der Ausgangsspannungen +/- Uint des Integrators IT der Steuer- und Auswerteschaltung SAS zugeführt. Diese bestimmt durch Vergleich der Beträge der am Ende des zweiten und vierten Schrittes gespeicherten Spannungswerte die Polaritätsrichtung der Elektroden E1, E2 des Prüflingkondensators.

Der Ablauf der Polaritätsprüfung in der erfindungsgemässen Vorrichtung wird an Hand des in der Figur dargestellten Beispieles nachfolgend im Detail beschrieben.

Zu Beginn des ersten Schrittes wird der Integrator IT bevorzugt über die Steuerleitung ST3 von der Steuer- und Auswerteschaltung SAS abgeschaltet. Dies geschieht im Beispiel der Figur durch Schließen eines dritten Umschalter S3, welcher einen Kondensator Ci in der Rückführung eines Operationsverstärkers N2 kurzschließt. Anschließend aktiviert die Steuer- und Auswerteschaltung SAS den ersten Umschalter S1 in der schaltbaren Gleichspannungsquelle QU derart, daß die Meßspannung bevorzugt mit positivem Potential +Uref an der ersten Elektrode E1 anliegt. Schließlich wird über die Steuerleitung ST2 der zweite Umschalter S2 derart aktiviert, daß die zweite Elektrode E2 des Prüflingkondensators Cx mit dem Massebezugspotential MP verbunden ist. Bei der in der Figur dargestellten Ausführungsform wird dies dadurch erreicht, daß der Umschalter S2 die Elektrode E2 direkt mit dem Ausgang eines Operationsverstärkers N1 im Inneren des Strom-Spannungsumsetzer UI verbindet. Dessen Rückführung mit dem Widerstand Rm ist in diesem Zustand geöffnet, so daß die Elektrode E2 mit dem Massebezugspotential MP an einem der Versorgungsspannungsanschlüsse des Operationsverstärkers N1 in Verbindung steht.

Der erste Zeitraum T1 für die Dauer dieses ersten Schrittes wird bevorzugt so gewählt,daß an dessen Ende bei Vorliegen der Richtigpolung des Prüflingkondensators ein annähernd konstanter Reststrom fließt, und andererseits bei Vorliegen einer Falschpolung noch keine irreversible Beschädigung des Prüflingkondensators eingetreten ist. Die "Ladezeit" T1 muß folglich so gewählt werden, daß bei Richtigpolung am Ende des ersten Zeitraumes "quasistationäre" Verhältnisse eingetreten sind, und der Ladestrom annähernd auf die Größe des üblichen Leckstromes abgesunken ist. Bevorzugt entspricht die Dauer des ersten Zeitraumes T1 mindestens dem dreifachen, bevorzugt dem zehnfachen Wert der Aufladezeitkonstante des Prüflingkondensators, d.h.

$$T1 = T_L = (3...10) \cdot \tau = (10 \cdot Ri) \cdot Cx, \quad (Gl.1)$$

wobei Ri der Innenwiderstand der schaltbaren Gleichspannungsquelle QU ist.

In einem sich anschließenden zweiten Schritt wird nun für die Dauer eines zweiten Zeitraumes T2 der zweite Umschalter S2 von der Steuer- und Auswerteschaltung SAS bevorzugt über die Steuerleitung ST2 derart aktiviert, daß die zweite Elektrode E2 des Prüflingkondensators Cx mit dem Eingang des Strom-Spannungsumsetzers IU verbunden ist. Gemäß der Darstellung in der Figur ist in diesem Fall die Rückführung des Operationsverstärkers N1 über den Widerstand Rm geschlossen und die Elektrode E2 mit dessen invertierenden Eingang verbunden. Der bei anliegender Meßspannung +Uref in diesem Moment noch durch den Prüflingkondensator Cx fließende Reststrom wird vom Strom-Spannungsumsetzer IU in eine Ausgangsspannung -Um umgesetzt. Der zu Beginn des zweiten Zeitraumes T2 bevorzugt durch Öffnen des Schalters S3 in der Rückführung zugeschaltete Integrator IT integriert diesen Spannungswert -Um für den Zeitraum T2 auf und leitet das Integrationsergebnis in Form der Spannung +Uint der Steuer- und Auswerteschaltung SAS zu. Diese speichert den Spannungswert am Ende des zweiten Zeitraumes T2.

Der zweite Zeitraum T2 hat somit die Funktion einer "Meßzeit" und wird bevorzugt so groß gewählt, daß eine Meßspannung Uint am Ausgang des Integrators IT von auswertbarer Größe auftritt. Bevorzugt wird die Dauer des zweiten Zeitraumes T2 so gewählt, daß sie ein ganzzahliges Vielfaches der Periodendauer von einer die Vorrichtung versorgenden Netzwechselspannung beträgt. Die Netzwechselspannung speist bei dem in der Figur dargestellten Beispiel die schaltbare Gleichspannungsquelle QU, die Operationsverstärker N1, N2 im Strom-Spannungsumsetzer IU und dem Integrator IT, und versorgt die Steuer- und Auswerteschaltung SAS. Ist am Ende des zweiten Zeitraumes T2 die Summe der positiven und negativen Spannungszeitfläche einer Netzfrequenzperiode gleich 0, so heben sich alle in die erfindungsgemäße Vorrichtung eingekoppelten netzsynchronen Störungen auf. Die Übereinstimmung des "Meßzeitfensters", d.h. der Dauer des zweiten Zeitraumes T2, mit einer Netzfrequenzperiode verbessert somit die Genauigkeit der Spannung +Uint bzw. -Um am Ausgang des Integrators IT bzw. des Strom-Spannungsumsetzers IU.

Es schließt sich nun ein dritter Schritt an, welcher wiederum die Dauer des ersten Zeitraumes T1 aufweist. Es wird wiederum der Integrator IT bevorzugt durch Öffnen des Schalters S3 abgeschaltet und der zweite Umschalter S2 bevorzugt über die Steuerleitung ST2 derart aktiviert, daß die zweite Elektrode E2 mit dem Bezugspotential MP verbunden ist. Ferner wird die Gleichspannungsquelle QU durch entsprechende Aktivierung des ersten Umschalters S1 über die Steuerleitung ST1 derart geschaltet, daß die Meßspannung mit umgekehrtem Potential -Uref für die Dauer des ersten Zeitraumes T1 an die erste Elektrode E1 angelegt wird.

In einem vierten und letzten Schritt wird wiederum für die Dauer des zweiten Zeitraumes T2 der zweite Umschalter S2 so aktiviert, daß die zweite Elektrode E2 des Prüflingkondensators Cx mit dem Strom-Spannungsumsetzer IU verbunden ist. Der Reststrom, welcher bei unverändert mit umgekehrtem Potential anliegender Meßspannung am Ende des dritten und zu Beginn des vierten Schrittes durch den Prüflingkondensator fließt, wird auch in diesem Fall in eine Spannung +Um am Ausgang des Strom-Spannungsumsetzers IU umgesetzt. Diese wird von dem zugeschalteten Integrator IT für die Dauer von T2 integriert und am Ende des zweiten Zeitraumes T2 in Form des Spannungswertes -Uint bevorzugt dem Analog-Digitalumsetzer ADU in der Steuer- und Auswerteschaltung SAS zugeführt.

Diese kann nun durch Vergleich der Beträge der am Ende des zweiten und vierten Schrittes aufgetretenen und gespeicherten Spannungswerte +Uint und -Uint die Polaritätsrichtung der Elektroden E1, E2 des Prüflingkondensators Cx stimmen. Ergibt sich bei diesem Vergleich

$$|+Uint| < |-Uint| \qquad (Gl.2),$$

so lag die Meßspannung im ersten Schritt in Richtigpolung und im dritten Schritt in Falschpolung am Prüflingkondensator Cx an. Bei dem in der Figur dargestellten Beispiel bedeutet somit +Uref an der Elektrode E1 Richtigpolung und -Uref an E1 Falschpolung.

Ergibt der Vergleich der Beträge der gespeicherten Spannungswerte am Ende des vierten Schrittes dagegen

$$|+Uint| > |-Uint| \qquad (Gl.3),$$

so lag die Meßspannung im ersten Schritt in Falschpolung und im dritten Schritt in Richtigpolung an den Elektroden des Prüflingkondensators. Bei dem in der Figur dargestellten Beispiel bedeutet somit -Uref an der Elektrode E1 Falschpolung und +Uref an E1 Richtigpolung.

Voraussetzung für die ordnungsgemäße Funktionsfähigkeit der erfindungsgemäßen Schaltung ist, daß die Dauern T1 der Ladezeiten im ersten bzw. dritten Schritt und die Beträge der im ersten bzw. dritten Schritt am Prüflingkondensator anliegenden Ladespannungen |+Uref| bzw |-Uref| gleich sind.

Der Vorteil der erfindungsgemäßen Vorrichtung wird darin gesehen, daß die Gesamtdauer der Polaritätsprüfung kurz ist, und diese zudem aufgrund der Anpaßbarkeit der Dauern von "Ladezeit" T1 und von "Meßzeit" T2 optimal auf den jeweiligen Prüfkondensatortyp und dessen Kapazität abstimmbar ist. Insbesondere sind augrund des erfindungsgemäßen Einsatzes des Strom-Spannungsumsetzers IU im ersten und im dritten Schritt kurze Ladedauern durch eine entsprechend kurze Dauer des ersten Zeitraumes T1 möglich. Dies wird dadurch möglich, daß der erfindungsgemäße Strom-Spannungsumsetzer IU vorhandene Leckströme des Prüflingkondensators so "verstärken" kann, daß trotz einer nur kurzen Ladung im ersten bzw. dritten Schritt eine Polaritätserkennung u.U. schon zu Beginn des zweiten bzw. vierten Schrittes möglich ist.

Ferner kann dann, wenn die zu Beginn des zweiten und vierten Schrittes auftretenden Leckströme insbesondere bei kleinen Prüflingkondensatoren nur geringe Werte aufweisen, eine weitere "Verstärkung" durch Aufintegration im nachgeschalteten Integrator IT erreicht werden. Die hierdurch erreichbare "Feinauflösung" der Kondensatorreststströme im zweiten und vierten Schritt trägt ebenfalls bei zur Erreichung von sowohl kurzen "Ladezeiten" T1 im ersten und dritten Schritt, als auch kurzen "Meßzeiten" T2 im zweiten und vierten Schritt.

Hierdurch ist es zum einen möglich, die Polarität eines Prüflingkondensators mit geringem Zeitaufwand zu bestimmen. Die erfindungsgemäße Vorrichtung kann somit bevorzugt dort eingesetzt werden, wo eine Polaritätsbestimmung im Dauerbetrieb bei hohen Taktfreguenzen benötigt wird. Dies ist insbesondere bei der selbsttätigen Bestükkung von Leiterplatten mit elektrischen Bauelementen in vollautomatischen Bestückungsautomaten der Fall. Zum anderen wird ein jeder Prüflingkondensator aufgrund der kurzen Lade- und Meßzeiten nur gering elektrisch belastet, so daß eine Beschädigung desselben durch die erfindungsgemäße Vorrichtung mit Sicherheit auszuschließen ist. Für die Dauer der Schritte eins und zwei, und der Schritte drei und vier, d.h. jeweils für die Summe aus erstem und zweitem Zeitraum $T1 + T2$, liegt ein Prüflingkondensator Cx an positiver bzw. negativer Meßspannung +Uref bzw. -Uref. Doch nur eine dieser Spannungsrichtungen bildet die Richtigpolung, während die andere Spannungsrichtung den Kondensator in Falschpolung belastet. Die erfindungsgemäße Vorrichtung ermöglicht durch kurze Lade- und Meßzeiten jeweils ein nur kurzzeitiges Anliegen der möglicherweise falsch gepolten Meßspannung. Die Zerstörung eines Prüflings ist somit mit Sicherheit ausgeschlossen.

Gemäß einer weiteren Ausführung der Erfindung kann die gesamte Dauer der Polaritätsprüfung weiter verringert werden. Dabei werden die jeweils zu Beginn des zweiten und vierten Schrittes am Ausgang des Strom-Spannungsumsetzers UI auftretenden Spannungswerte -Um und +Um vom Analog-Digitalumsetzer ATU erfaßt und in der Steuer- und Auswerteschaltung SAS gespeichert. Wei

sen die Beträge dieser Spannungswerte eine auswertbare Differenz auf, so kann bereits hieraus die Steuer- und Auswerteschaltung SAS die Polaritätsrichtung der Elektroden E1, E2 des Prüflingkondensators Cx genau bestimmen.

Im diesem Fall kann zumindest der vierte Schritt und somit die zweite "Meßzeit" T2 entfallen. Zur Polaritätsbestimmung werden dann der Betrag der unmittelbar am Ende des dritten Schrittes am Ausgang des Strom- und Spannungsumsetzers IU anstehender Spannung |-Um| gemeinsam mit dem Spannungsbetrag |+Um| am Ende des ersten Schrittes oder mit dem Spannungsbetrag |+Uint| am Ende des zweiten Schrittes herangezogen. Dieser Fall wird insbesondere bei großen Kondensatoren möglich sein, bei denen aufgrund der ausreichend großen Leckströme zu Beginn des zweiten und vierten Schrittes ausreichend große, auswerbare Spannungswerte |+/-Um| am Ausgang von IU auftreten.

Ergibt der Vergleich der Spannungswerte

$$|\text{-Um}| < |\text{+Um}| \qquad \text{(Gl.4)},$$

so tritt die Richtigpolung des Prüflingkondensators beim ersten Schritt und die Falschpolung beim dritten Schritt auf. Ergibt der Spannungsvergleich dagegen

$$|\text{-Um}| > |\text{+Um}| \qquad \text{(Gl.5)},$$

so tritt die Falschpolung des Prüflingkondensators beim ersten Schritt und die Richtigpolung beim dritten Schritt auf. Liegt somit eine auswertbare Differenz zwischen dem Spannungsbetrag

$$|\text{-Um}| \qquad \text{(Gl.6)}$$

zu Beginn des zweiten Schrittes und dem Spannungsbetrag

$$|\text{+Um}| \qquad \text{(Gl.7)}$$

zu Beginn des vierten Schrittes vor, so können diese Spannungswerte in der gleichen Weise wie die Spannungen +/-Uint am Ausgang des Integrators IT zur Polaritätsbestimmung verwendet werden. Dies hat den Vorteil, daß das Ende des vierten Schrittes und somit die Bildung des Spannungswertes -Uint nach Ablauf des zweiten Zeitraumes T2 nicht mehr abgewartet werden muß. Vielmehr kann die Polaritätsbestimmung bereits nach Ablauf der ersten drei Schritte erfolgen.

Gemäß einer weiteren Ausführung der Erfindung kann vor Beginn des ersten Schrittes und/oder zwischen dem zweiten und dem dritten Schritt das Bezugspotential MP bevorzugt für die Dauer des ersten Zeitraumes T1 an die erste Elek

trode E1 des Prüflingkondensators Cx gelegt werden. Hierzu weist bei dem in der Figur dargestellten Beispiel der erste Umschalter S1 der schaltbaren Gleichspannungsquelle QU eine dritte Schaltposition auf, welche zwischen den Schaltpositionen +Uref und -Uref angeordnet ist. Diese Ausführung hat den Vorteil, daß vor der ersten Aufladung des Prüflingkondensators im ersten Schritt bzw. dessen Umladung im dritten Schritt eine definierte Kondensatorentladung herbeigeführt wird. Durch den Einschub einer Entladung zumindest zwischen den zweiten und dritten Schritt wird zwar die Gesamtdauer des Meßvorganges z.B. um einen weiteren ersten Zeitraum T1 verlängert. Doch kann hierdurch die Genauigkeit der Steuer- und Auswerteschaltung SAS zugeführten Spannungswerte so erhöht werden, das eine Polaritätsrichtungsbestimmung der Elektroden des Prüflinges unter Umständen bereits unter Zuhilfenahme der Spannungen |+/-Um| am Ausgang des Strom-Spannungsumsetzers IU möglich ist, und gegebenfalls deren Integration zu den Werten |+/-Uint| entfallen kann.

Der Betrag der Meßspannung Uref am Ausgang der schaltbaren Gleichspannungsquelle wird bevorzugt so gewählt, das dieser in jedem Falle einen unteren Grenzwert überschreitet. In der Praxis hat sich am Beispiel von gepolten Tantalkondensatoren gezeigt, daß der Wert

|Uref| ≥ 3 V     (Gl.8)

gewählt werden sollte. Andererseits sollte der Meßspannungsbetrag möglichst 80 % des Nennspannungswertes des jeweiligen Prüflingkondensators betragen. Kann dieser Betrag z.B. aufgrund der Begrenzung der Meßspannung durch die Betriebsversorgungsspannung der erfindungsgemäßen Vorrichtung nicht eingestellt werden, so sollte der Meßspannungsbetrag möglichst an der Obergrenze des Wertebereiches zwischen 10 % und 80 % der Nennspannung des jeweiligen Prüflingkondensators Cx liegend gewählt werden.

**Patentansprüche**

1. Vorrichtung zur automatischen Bestimmung der Polarität von gepolten Kondensatoren, insbesondere von gepolten Elektrolytkondensator, mit
   a) einer schaltbaren Gleichspannungsquelle (QU), welche bevorzugt mittels eines ersten Umschalters (S1) eine Meßspannung (Uref) zumindest mit positivem oder negativem Potential (+Uref,-Uref) an die erste Elektrode (E1) eines Prüflingkondensators (Cx) anlegt,
   b) einem Strom-Spannungsumsetzer (IU),
   c) einem zweiten Umschalter (S2), welcher die zweite Elektrode (E2) des Prüflingkondensators (Cx) entweder mit einem Bezugspotential (MP) oder mit dem Eingang des Strom-Spannungsumsetzers (IU) verbindet,
   d) einem Integrator (IT), der am Ausgang des Strom-Spannungsumsetzers (IU) angeschlossen ist, und
   e) einer Steuer- und Auswerteschaltung (SAS), welche
      e1) in einem ersten Schritt für die Dauer eines ersten Zeitraumes (T1) den Integrator (IT) abschaltet, den zweiten Umschalter (S2) aktiviert zur Verbindung der zweiten Elektrode (E2) mit dem Bezugspotential (MP) und den ersten Umschalter (S1) aktiviert zum Anlegen der Meßspannung (+Uref) an die erste Elektrode (E1),
      e2) in einem zweiten Schritt für die Dauer eines zweiten Zeitraumes (T2) den zweiten Umschalter (S2) aktiviert zur Verbindung der zweiten Elektrode (E2) mit dem Strom-Spannungsumsetzer (IU), den Integrator (IT) zuschaltet und am Ende des zweiten Zeitraumes (T2) den Spannungswert (+Uint) des Integrators (IT) speichert,
      e3) in einem dritten Schritt für die Dauer des ersten Zeitraumes (T1) den Integrator (IT) abschaltet, den zweiten Umschalter (S2) aktiviert zur Verbindung der zweiten Elektrode (E2) mit dem Bezugspotential (MP) und den ersten Umschalter (S1) aktiviert zum Anlegen der Meßspannung mit umgekehrtem Potential (-Uref) an die erste Elektrode (E1),
      e4) in einem vierten Schritt für die Dauer des zweiten Zeitraumes (T2) den zweiten Umschalter (S2) aktiviert zur Verbindung der zweiten Elektrode (E2) mit dem Strom-Spannungsumsetzer (IU), den Integrator (IT) zuschaltet und am Ende des zweiten Zeitraumes (T2) den Spannungswert (-Uint) des Integrators (IT) speichert, und
      e5) durch Vergleich der Beträge der am Ende des zweiten und vierten Schrittes gespeicherten Spannungswerte (+Uint,-Uint) die Polaritätsrichtung der Elektroden (E1,E2) des Prüflingkondensators (Cx) bestimmt.

2. Vorrichtung nach Anspruch 1, wobei die Steuer- und Auswerteschaltung (SAS) die jeweils zu Beginn des zweiten und vierten Schrittes am Ausgang des Strom-Spannungsumsetzers (IU) auftretenden Spannungswerte (-Um,+Um) speichert, und beim Auftreten einer auswertbaren Differenz zwischen den Beträgen der Spannungswerte diese zur Bestimmung der Polaritätsrichtung der Elektroden (E1,E2) des Prüflingkondensators (Cx) heranzieht.

3. Vorrichtung nach einem der vorangegangenen Ansprüche, wobei vor Beginn des ersten Schrittes und/oder zwischen dem zweiten und dritten Schritt das Bezugspotential (MP) bevorzugt für die Dauer des ersten Zeitraumes (T1) an die erste Elektrode (E1) des Prüflingkondensators (Cx) angelegt wird.

4. Vorrichtung nach einem der vorangegangenen Ansprüche, wobei die Dauer des ersten Zeitraumes (T1) so gewählt wird, daß an dessen Ende bei Richtigpolung des Prüflingkondensators (Cx) ein annähernd konstanter Reststrom fließt.

5. Vorrichtung nach einem der vorangegangenen Ansprüche, wobei die Dauer des zweiten Zeitraumes (T2) so gewählt wird, daß sie ein ganzzahliges Vielfaches der Periodendauer einer die Vorrichtung versorgenden Netzwechselspannung beträgt.

6. Vorrichtung nach einem der vorangegangenen Ansprüche, wobei der Betrag der Meßspannung (Uref) so gewählt wird, daß er in jedem Fall einen unteren Grenzwert (3V) überschreitet und ansonsten möglichst an der Obergrenze des Wertebereiches zwischen 10 % und 80 % der Nennspannung des jeweiligen Prüflingkondensators (Cx) liegend gewählt wird.

7. Verwendung der Vorrichtung nach einem der vorangegangenen Ansprüche in einer Einrichtung zur automatischen Bestückung von Leiterplatten mit elektrischen Bauelementen, insbesondere in einem SMD-Bestückungsautomaten.

Europäisches Patentamt

# EUROPÄISCHER RECHERCHENBERICHT

Nummer der Anmeldung

EP 94 10 4116

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| D,A | EP-A-0 258 517 (SIEMENS)<br>* Zusammenfassung; Abbildung 2 *<br>--- | 1 | G01R31/02<br>H05K13/08 |
| A | PATENT ABSTRACTS OF JAPAN<br>vol. 6, no. 225 (P-154) 10. November 1982<br>& JP-A-57 128 857 (MATSUO)<br>* Zusammenfassung *<br>--- | 1 | |
| A | EP-A-0 376 782 (LCC)<br>* Zusammenfassung; Abbildung 4 *<br>* Spalte 4, Zeile 42 - Spalte 5, Zeile 45 *<br>--- | 1 | |
| A | DE-A-28 20 404 (SIEMENS)<br>* Seite 5, Zeile 11 - Zeile 16; Ansprüche *<br>--- | 1 | |
| A | PATENT ABSTRACTS OF JAPAN<br>vol. 15, no. 351 (E-1108) 5. September 1991<br>& JP-A-03 136 312 (YAMATAKE HONEYWELL)<br>* Zusammenfassung *<br>--- | 1 | |
| A | IBM TECHNICAL DISCLOSURE BULLETIN,<br>Bd.26, Nr.2, Juli 1983, NEW YORK US<br>Seiten 579 - 581<br>D.S.ROOP ET AL. 'Reverse Capacitor Tester'<br>* das ganze Dokument *<br>----- | 1 | |

RECHERCHIERTE SACHGEBIETE (Int.Cl.5)

G01R

Der vorliegende Recherchenbericht wurde für alle Patentansprüche erstellt

| Recherchenort | Abschlußdatum der Recherche | Prüfer |
|---|---|---|
| BERLIN | 11. August 1994 | Fritz, S |